# EUROPÄISCHE PATENTSCHRIFT

(11) **EP 1 883 108 B1**
(45) Veröffentlichungstag und Bekanntmachung des Hinweises auf die Patenterteilung: **11.09.2013**
(21) Anmeldenummer: 07013421.8
(22) Anmeldetag: 10.07.2007
(51) Int. Cl.: H01L 23/48, H01L 25/07, H01L 23/00

(54) **Anordnung mit einem Leistungshalbleiterbauelement und einer Kontakteinrichtung**
Arangement with a power semiconductor device and a contact device
Arangement doté d'un composant semi-conducteur de puissance et d'un dispositif de contact

(30) Priorität: 28.07.2006 DE 102006034964
(43) Veröffentlichungstag der Anmeldung: 30.01.2008
(73) Patentinhaber: SEMIKRON Elektronik GmbH & Co. KG, 90431 Nürnberg (DE)
(72) Erfinder: Schlötterer, André, 90478 Nürnberg (DE)

(56) Entgegenhaltungen:
- WO-A-2005/020383
- DE-A1- 2 405 930
- DE-A1- 10 254 617
- DE-A1-102004 050 588
- DE-A1-102004 057 421

## Beschreibung

Es wird eine Anordnung mit einer Kontakteinrichtung für den Steueranschluss eines Leistungshalbleiterbauelements in Scheibenzellen und Leistungshalbleitermodulen beschrieben. Eine derartige Kontakteinrichtungen ist beispielhaft aus der DE 10 2004 058 946 A,1 der DE 102 54 617 A1 und DE 10 2004 050 588 bekannt.

Erstgenannte Druckschrift offenbart eine Scheibenzelle mit einem Steueranschluss zum Steuerkontakt des Leistungshalbleiterbauelements, wobei der Steueranschluss ausgebildet ist als ein Drahtelement welches im Bereich des Leistungshalbleiterbauelements in einer Kunststoffhülse geführt ist. Diese Kunststoffhülse und somit die Kontaktfläche des Drahtes zum Steuerkontakt wird mittels einer Feder in Richtung des Leistungshalbleiterbauelements gedrückt. Eine derartige Ausgestaltung gemäß dem Stand der Technik ist einer rationellen Fertigung mit einer möglichst geringen Anzahl von einzelnen vorgefertigten Baugruppen nicht zugänglich.

Die zweitgenannte Druckschrift offenbart ebenfalls eine Scheibenzelle, allerdings mit einer Mehrzahl von Gateanschlüssen, die als flächige Metallformkörper ausgebildet sind und von einer zentral angeordneten Gateelektrode radial nach außen reichen. Hierbei verlaufen die Hauptflächen der Metallformkörper parallel zu den Hauptflächen des Leistungshalbleiterbauelements im Inneren der Scheibenzelle.

Letztgenannte Druckschrift offenbart eine Anordnung mit einem Leistungshalbleiterbauelement in einem Leistungshalbleitermodul oder einer Scheibenzelle, wobei oberhalb des Leistungshalbleiterbauelements ein Formkörper angeordnet ist, der im Bereich des Steueranschlusses eine Ausnehmung mit einem Widerlager aufweist. Die Kontakteinrichtung selbst besteht aus einer Kontaktfeder mit einem stiftartigen Fortsatz an demjenigen Federende, das den Steueranschluss kontaktiert, und weiterhin mit einer mittels eines Metallformteils gebildeten Verbindung mit einem Anschlusskabel zur externen Verbindung am anderen Federende. Die Kontakteinrichtung weist hierzu eine Isolierstoffhülse mit darin angeordneter Kontaktfeder auf, wobei die Isolierstoffhülse weiterhin Rastnasen aufweist, die zusammen mit einem Widerlager des Formkörpers eine Schnapp- Rast- Verbindung bilden. Nachteilig an dieser Ausgestaltung der Kontakteinrichtung ist, dass sie ein große Bauhöhe aufweist und daher in manchen kompakten Leistungshalbleitermodulen oder Scheibenzellen nicht anordenbar ist.

Der Erfindung liegt die Aufgabe zugrunde eine Anordnung mit einer Kontakteinrichtung für einen Steuer- und /oder Hilfsanschluss von Leistungshalbleiterbauelementen in Scheibenzellen und Leistungshalbleitermodulen vorzustellen, die kompakt und universell einsetzbar ist, einen dauerhaft sicheren elektrischen Kontakt gewährleistet und einer einfachen Montage in Form einer Baugruppe zugänglich ist.

Die Aufgabe wird erfindungsgemäß gelöst, durch eine Anordnung mit den Merkmalen des Anspruchs 1. Bevorzugte Ausführungsformen sind in den Unteransprüchen beschrieben.

Der Grundgedanke der Erfindung geht aus von einem Leistungshalbleitermodul, vorzugsweise in Druckkontaktierung mit einem oder mehreren Leistungshalbleiterbauelementen oder einer Scheibenzelle. In einer Scheibenzelle ist typischerweise nur ein Leistungshalbleiterbauelement angeordnet, allerdings gibt es Sonderformen mit einer Mehrzahl von Leistungshalbleiterbauelementen in einem Gehäuse.

Die Erfindung bezieht sich auf Leistungshalbleitermodule oder auf Scheibenzellen mit mindestens einem gesteuerten Leistungshalbleiterbauelement, wie einem Thyristor oder einem Transistor. Diese weisen pro gesteuertem Leistungshalbleiterbauelement einen Steueranschluss und meist auch mindestens einen Hilfsanschluss auf, die jeweils mit einer externen Kontakteinrichtung verbunden sind.

Die erfindungsgemäße Anordnung mit einem Leistungshalbleiterbauelement in einem Leistungshalbleitermodul oder einer Scheibenzelle weist hierbei oberhalb des Leistungshalbleiterbauelements einen Formkörper mit mindestens zwei Ausnehmungen auf. Mindestens zwei Kontakteinrichtungen zur Hilfs- oder Steueranschlusskontaktierung des Leistungshalbleiterbauelements ist zur Anordnung in einer jeweils zugeordneten derartigen Ausnehmung vorgesehen.

Die Kontakteinrichtung selbst besteht aus einer Kontaktfeder mit einem stiftartigen Fortsatz an demjenigen ersten Federende, das dem Leistungshalbleiterbauelement zugewandt ist. An dem zweiten Federende ist ein Metallformkörper vorgesehen mit einer ersten Verbindungseinrichtung ausgestaltet als flächiger Abschnitt des Metallformkörpers parallel angeordnet zum Leistungshalbleiterbauelement und mit einer zweiten Verbindungseinrichtung zur Verbindung mit einem Anschlusskabel. Weiterhin weist die Kontakteinrichtung ein mehrteiliges Isolierstoffgehäuse zur Anordnung der Kontaktfeder und des Metallformkörpers, auf. Hierzu weist dieses Isolierstoffgehäuse eine erste Ausnehmung für den stiftartigen Fortsatz und eine zweite seitlich angeordnete Ausnehmung für die zweite Verbindungseinrichtung auf.

Der erfinderische Gedanke wird anhand der Ausführungsbeispiele in den Fig. 1 bis 3 näher erläutert.

Fig. 1 zeigt eine dreidimensionale Explosionsdarstellung eines Leistungshalbleitermoduls mit einer erfindungsgemäßen Kontakteinrichtung.

Fig. 2 zeigt zwei erfindungsgemäße Kontakteinrichtungen angeordnet in einem Formkörper.

Fig. 3 zeigt eine Detaildarstellung einer erfindungsgemäßen Kontakteinrichtung.

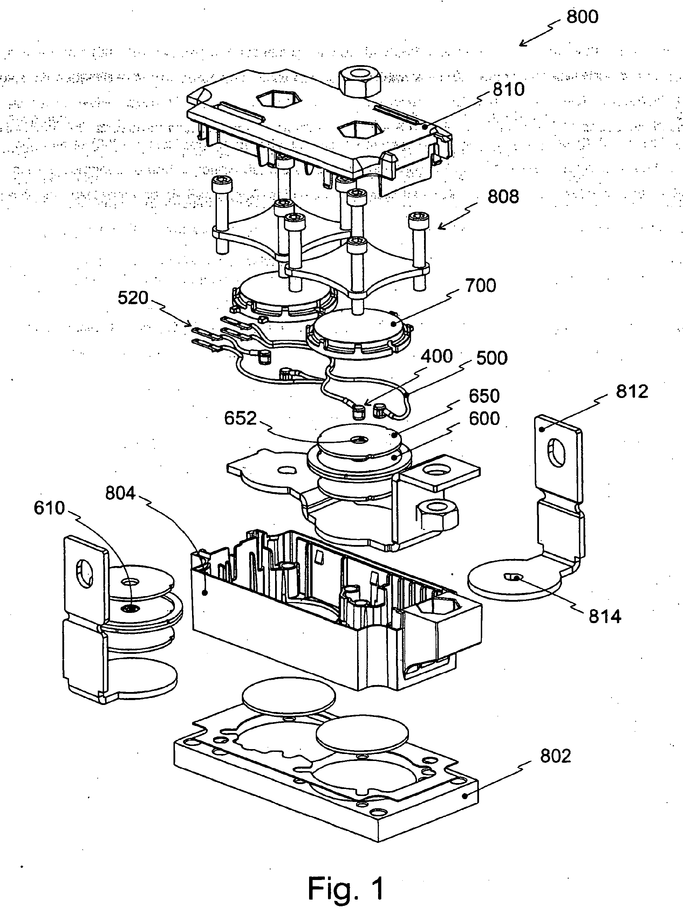

Fig. 1 zeigt eine dreidimensionale Explosionsdarstellung einer erfindungsgemäßen Anordnung in Ausgestaltung eines Leistungshalbleitermoduls (800) mit einer Kontakteinrichtung (400). Dargestellt ist ein Leistungshalbleitermodul (800) mit zwei Thyristoren (600) aufgebaut in Druckkontakttechnik. Auf einer Grundplatte (802) sind in geeigneter Weise angeordnet:
- Isolationsmaterial zur elektrischen Isolation der Strom führenden Teile des Leistungshalbleitermoduls (800) von der Grundplatte (802);
- die beiden Thyristoren (600) mit geeigneten elektrischen Lastverbindungselementen (812);
- zwei Formkörper (700) zur Aufnahme der Kontakteinrichtungen und zur Einleitung des Drucks auf die Leistungshalbleiterbauelemente
- eine Druckkontakteinrichtung (808) und
- ein Gehäuse (804) mit Deckel (810).

Häufig werden die Leistungshalbleiterbauelemente (600) in druckkontaktierten Leistungshalbleitermodulen (800) und Scheibenzellen beidseitig mit je einem flächigen Metallkörper (650) verbunden, dessen Wärmeausdehnungskoeffizient zwischen dem Wärmeausdehnungskoeffizienten des Leistungshalbleiterbauelements (600) und dem Wärmeausdehnungskoeffizienten einer anschließenden Kontakteinrichtung (812) der Leistungsanschlüsse liegt, um den thermischen Stress für das Leistungshalbleiterbauelement (600) zu verringern. Die Verbindung des Leistungshalbleiterbauelements (600) mit den flächigen Metallkörpern (650), die vorzugsweise aus Molybdän bestehen, kann durch unterschiedliche Verfahren realisiert werden, beispielhaft durch Verlöten, Verkleben oder Druckkontaktierung der beiden Partner. Der flächige Metallkörper (650) weist typischerweise eine Dicke in der Größenordnung von einigen zehntel bis einigen Millimetern auf.

Die Kontakteinrichtung (400) ist hier eine Baugruppe für den Zusammenbau des Leistungshalbleitermoduls (800), die in den Formkörper (700) angeordnet ist und somit einer einfachen Montage des Leistungshalbleitermoduls (800) zugänglich ist. Jeweils zwei Kontakteinrichtungen (400) werden hierzu in die zugeordneten Formkörper (700) eingesetzt. Diese Formkörper (700) sind aus einem duroplasten Kunststoff gebildet, da sie nur der Druckeinleitung über die Druckkontakteinrichtung (808) nicht aber der elektrischen Verbindung dienen, da die Leistungsanschlüsse (812) hier als metallische Anschlusslaschen ausgeführt sind. Die elektrische Verbindung der Kontakteinrichtung (400) nach außen wird jeweils mittels eines Kabels (500) mit einem damit verbundener Stecker (520) gebildet. Das Kabel (500) ist mit der Kontakteinrichtung (400) vorzugsweise mittels einer Crimpverbindung (220, 510) verbunden.

Das Kunststoffgehäuse (300) der Kontakteinrichtung (400) dient zusätzlich der elektrischen Isolation beispielhaft des Steuersignals vom Leistungsanschluss, der durch den metallischen Formkörper (812) gebildet wird.

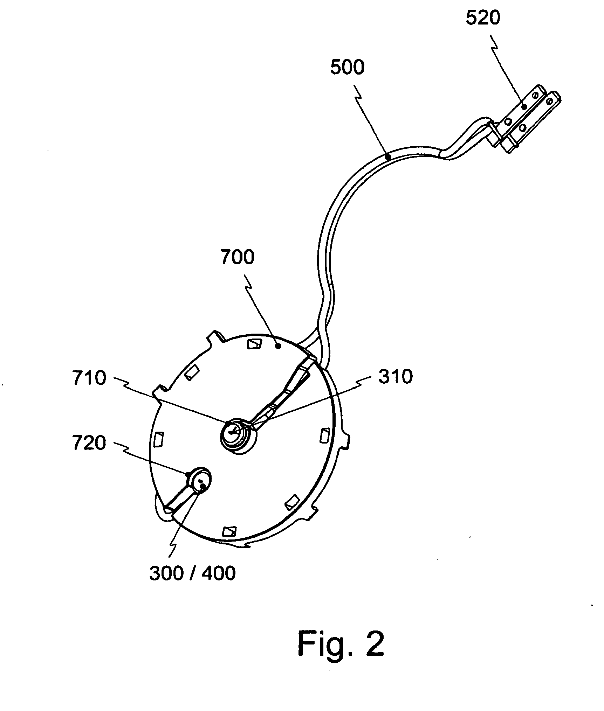

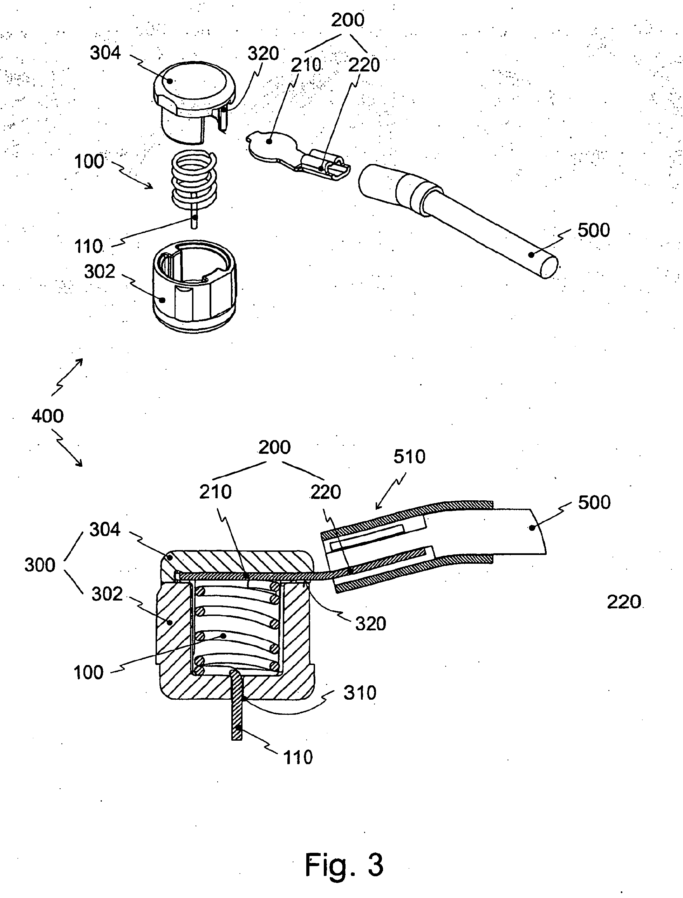

Fig. 2 zeigt zwei erfindungsgemäße Kontakteinrichtungen (400) angeordnet in einem Formkörper (700) als Detaildarstellung der Fig. 1. Dargestellt ist der Formkörper (700) aus einem vorzugsweise duroplasten Kunststoff mit zwei Ausnehmungen (710, 720) für jeweils eine Kontakteinrichtung (400). Jede Kontakteinrichtung (400) weist ein Kunststoffgehäuse (300) auf, wobei auf der dem Leistungshalbleiterbauelement (600, vgl. Fig. 1) zugewandten Seite eine Ausnehmung (310) vorgesehen ist. Durch diese Ausnehmung (310) ragt der stiftartige Fortsatz (110) der Kontaktfeder (100, vgl. Fig. 3).

Dieser stiftartige Fortsatz (110) dient bei der zentral angeordneten Kontakteinrichtung (400) der Kontaktierung des Steueranschlusses (610) des Leistungshalbleiterbauelements (600). Hierzu reicht die Kontakteinrichtung (400) zur Kontaktierung des Steueranschlusses teilweise durch eine Ausnehmung (650, 814, vgl. Fig. 1) mindestens eines zwischen dem Leistungshalbleiterbauelement und dem Formkörper angeordneten flächigen Metallformkörper (650 812, vgl. Fig. 1) hindurch. Somit ist der stiftartige Fortsatz (110) mit der Steuerkontaktfläche (610) des Leistungshalbleiterbauelements (600) elektrisch leitend verbunden.

Die nicht zentral angeordnete Kontakteinrichtung (400) dient der Hilfskontaktierung des Leistungshalbleiterbauelements (600), wie sie beispielhaft als Hilfsemitter bekannt ist. Hierzu ist eine identisch zur zentral angeordneten Kontakteinrichtung (400) ausgebildete weitere Kontakteinrichtung (400) ebenfalls in dem Formkörper (700) angeordnet. Allerdings ist die zugeordnete Ausnehmung (720) tiefer ausgebildet, so dass der stiftartige Fortsatz (110) der Kontakteinrichtung (400) zur Kontaktierung des Hilfsanschlusses mit dem zwischen dem Leistungshalbleiterbauelement (600) und dem Formkörper (700) angeordneten flächigen Metallformkörper (650) oder einem Leistungsanschlusselement (812) elektrisch leitend verbunden ist.

Ebenfalls dargestellt sind Anschlusskabel (500) ausgehend von den Kontakteinrichtungen (400) zu jeweils einem Stecker (520), der die zugeordneten externen Anschlüsse des Leistungshalbleitermoduls (800) ausbildet.

Fig. 3 zeigt eine Detaildarstellung einer erfindungsgemäßen Kontakteinrichtung (400) einerseits als Explosionsdarstellung wie auch im Schnitt. Diese Kontakteinrichtung (400) besteht aus einem mehrteiligen, hier zweiteiligen, Isolierstoffgehäuse (300), einer Kontaktfeder (100) und einem Metallformkörper (200).

Die Kontaktfeder (100) selbst ist als Schraubenfeder mit einem stiftartigen Fortsatz (110) am ersten Federende ausgebildet. Dieser Fortsatz (110) dient der Kontaktierung beispielhaft des Steueranschlusses (610) des Leistungshalbleiterbauelements (600). Der federnde Abschnitt der Kontaktfeder (100) dient der über die Lebensdauer der Scheibenzelle bzw. des Leistungshalbleitermoduls (800) konstanten Druckeinleitung und damit sicheren Kontaktierung des Steueranschlusses (610). Das zweite Federende dient dem elektrischen Kontakt zum Metallformkörper (200).

Dieser Metallformkörper (200) weist als erste Verbindungseinrichtung (210) zur Kontaktfeder (100) einen ersten flächigen Abschnitt parallel angeordnet zum Leistungshalbleiterbauelement (600) auf. Ebenso weist er eine zweite Verbindungseinrichtung (220) zur Verbindung mit einem Anschlusskabel (500) auf. Diese Verbindungseinrichtung (220) des Metallformkörpers (200) ist als Crimpverbindung zu dem Anschlusskabel (500), ausgebildet.

Das Isolierstoffgehäuse (300) ist zweistückig ausgestaltet wobei der obere Teil (304) in den unteren Teil (302) teilweise hineinragt und somit die beiden Teile zueinander fixiert sind. Alternativ kann eine nicht dargestellte Schnapp- Rast- Verbindung zwischen den beiden Teilen vorgesehen werden. Durch die Verbindung der beiden Teile (302, 304) wird ein flächiger Abschnitt, die erste Verbindungseinrichtung (210), des Metallformkörper (200) auf das zweite Federende gepresst, gleichzeitig die Feder (100) selbst mäßig gespannt.

Der untere Teil (302) des Isolierstoffgehäuses (300) weist auf seiner dem Leistungshalbleiterbauelement (600, vgl. Fig. 1 und 2) zugewandten Seite eine Ausnehmung (310) als Durchführung für den stiftartigen Fortsatz (110) der Kontaktfeder (100) auf. Der obere Teil (304) des Isolierstoffgehäuses (300) weist eine seitliche Ausnehmung (320) zur Durchführung der Verbindungseinrichtung (220) des Metallformkörpers (200) auf.

## Patentansprüche

1. Anordnung mit einem Leistungshalbleiterbauelement (600) in einem Leistungshalbleitermodul (800) oder einer Scheibenzelle, wobei oberhalb des Leistungshalbleiterbauelements (600) ein Formkörper (700) angeordnet ist, der mindestens zwei Ausnehmungen (710, 720) aufweist,
mit mindestens zwei Kontakteinrichtungen (400) zur Hilfs- oder Steueranschlusskontaktierung des Leistungshalbleiterbauelements (600), wobei die jeweilige Kontakteinrichtung (400) zur Anordnung in einer zugeordneten Ausnehmung (710, 720) vorgesehen ist und besteht
aus einer Kontaktfeder (100) mit einem stiftartigen Fortsatz (110) an demjenigen ersten Federende, das dem Leistungshalbleiterbauelement (600) zugewandt ist, und mit einem an dem zweiten Federende angeordneten Metallformkörper (200) mit einer ersten Verbindungseinrichtung (210) ausgestaltet als flächiger Abschnitt des Metallformkörpers (200) parallel angeordnet zum Leistungshalbleiterbauelement (600) und mit einer zweiten Verbindungseinrichtung (220) zur Verbindung mit einem Anschlusskabel (500) und
aus einem mehrteiligen Isolierstoffgehäuse (300) zur Anordnung der Kontaktfeder (100) und des Metallformkörpers (200), wobei dieses Isolierstoffgehäuse (300) eine erste Ausnehmung (310) für den stiftartigen Fortsatz (110) und eine zweite seitlich angeordnete Ausnehmung (320) für die zweite Verbindungseinrichtung (220) aufweist.

2. Anordnung nach Anspruch 1,
wobei das Isolierstoffgehäuse (300) zweistückig ausgebildet ist und die beiden Teile (302, 304) über eine Schnapp- Rast- Verbindung zueinander angeordnet sind.

3. Anordnung nach Anspruch 1,
wobei das Isolierstoffgehäuse (300) zweistückig ausgebildet ist und die beiden Teile (302, 304) ineinander angeordnet sind und hierdurch der Metallformkörper (200) auf das zweite Federende gepresst wird und die Feder (100) selbst leicht gespannt wird.

4. Anordnung nach Anspruch 1,
wobei die Kontaktfeder (100) als Schraubenfeder ausgebildet ist.

5. Anordnung nach Anspruch 1,
wobei die zweite Verbindungseinrichtung (220) des Metallformkörpers (200) als Crimpverbindung zu dem Anschlusskabel (500), ausgebildet ist.

6. Anordnung nach Anspruch 1,
wobei die Kontakteinrichtung (400) zur Kontaktierung des Steueranschlusses teilweise durch mindestens eine Ausnehmung (652, 814) mindestens eines zwischen dem Leistungshalbleiterbauelement (600) und dem Formkörper (700) angeordneten flächigen Metallformkörpers (650, 812) hindurch reicht und hierbei der stiftartige Fortsatz (110) mit der Steuerkontaktfläche (610) des Leistungshalbleiterbauelements (600) elektrisch leitend verbunden ist.

7. Anordnung nach Anspruch 1,
wobei der stiftartige Fortsatz (110) der Kontaktfeder (100) der Kontakteinrichtung (400) zur Kontaktierung des Hilfsanschlusses mit dem zwischen dem Leistungshalbleiterbauelement (600) und dem Formkörper (700) angeordneten flächigen Metallformkörpers (650, 812) elektrisch leitend verbunden ist.

8. Anordnung nach Anspruch 1,
wobei eine nicht zentral angeordnete Ausnehmung (720) tiefer in dem Formkörper (700) ausgebildet ist als eine zentral angeordnete Ausnehmung (710).

## Claims

1. An arrangement with a power semiconductor component (600) in a power semiconductor module (800) or a disc cell, wherein a moulding (700), which has at least two recesses (710, 720), is arranged above the power semiconductor component (600),
with at least two contact apparatuses (400) for auxiliary or control connection contacting of the power semiconductor component (600), wherein the respective contact apparatus (400) is provided for arrangement in an assigned recess (710, 720) and consists
of a contact spring (100) with a pin-like extension (110) at the first spring end which faces the power semiconductor component (600) and with a metal moulding (200) arranged at the second spring end, configured with a first connecting apparatus (210) as flat section of the metal moulding (200) arranged parallel to the power semiconductor component (600) and with a second connecting apparatus (220) for connecting to a connection cable (500) and
of a multiple-part insulated housing (300) for the arrangement of the contact spring (100) and the metal moulding (200), wherein this insulated housing (300) has a first recess (310) for the pin-like extension (110) and a second laterally arranged recess (320) for the second connecting apparatus (220).

2. The arrangement according to Claim 1, wherein the insulated housing (300) is constructed in two pieces and the two parts (302, 304) are arranged with respect to one another via a snap-locking connection.

3. The arrangement according to Claim 1, wherein the insulated housing (300) is constructed in two pieces and the two parts (302, 304) are arranged inside one another and as a result of this, the metal moulding (200) is pressed onto the second spring end and the spring (100) itself is slightly tensioned.

4. The arrangement according to Claim 1, wherein the contact spring (100) is constructed as a coil spring.

5. The arrangement according to Claim 1, wherein the second connecting apparatus (220) of the metal moulding (200) is constructed as a crimped connection to the connection cable (500).

6. The arrangement according to Claim 1, wherein, for contacting the control connection, the contact apparatus (400) reaches to some extent through at least one recess (652, 814) of at least one flat metal moulding (650, 812) arranged between the power semiconductor component (600) and the moulding (700), and here, the pin-like extension (110) is electrically conductively connected to the control contact surface (610) of the power semiconductor component (600).

7. The arrangement according to Claim 1, wherein, for contacting the auxiliary connection, the pin-like extension (110) of the contact spring (100) of the contact apparatus (400) is electrically conductively connected to the flat metal moulding (650, 812) arranged between the power semiconductor component (600) and the moulding (700).

8. The arrangement according to Claim 1, wherein a non-centrally arranged recess (720) is constructed deeper in the moulding (700) than a centrally arranged recess (710).

## Revendications

1. Agencement avec un composant semi-conducteur de puissance (600) dans un module semi-conducteur de puissance (800) ou une diode à boîtier, un corps moulé (700) pourvu d'au moins deux évidements (710, 720) étant disposé au-dessus du composant semi-conducteur de puissance (600), avec au moins deux dispositifs de contact (400) pour le contact de borne auxiliaire ou de borne de commande du composant semi-conducteur de puissance (600), chaque dispositif de contact (400) étant prévu pour être mis en place dans un évidement (710, 720) correspondant et se composant d'un ressort de contact (100) avec un appendice en forme de goupille (110) sur la première extrémité de ressort à laquelle le composant semi-conducteur de puissance (600) est opposé, et avec un corps métallique moulé (200) disposé sur la deuxième extrémité de ressort, comportant un premier dispositif de connexion (210) réalisé sous forme de segment plat du corps métallique moulé (200) disposé parallèlement au composant semi-conducteur de puissance (600) et un deuxième dispositif de connexion (220) pour le raccord à un câble de connexion (500), et d'un boîtier en matériau isolant (300) en plusieurs pièces pour le logement du ressort de contact (100) et du corps métallique moulé (200), ledit boîtier en matériau isolant (300) présentant un premier évidement (310) pour l'appendice en forme de goupille (110) et un deuxième évidement (320) ménagé latéralement pour le deuxième dispositif de connexion (220).

2. Agencement selon la revendication 1, dans lequel le boîtier en matériau isolant (300) est réalisé en deux pièces et les deux pièces (302, 304) sont raccordées par une connexion à enclenchement.

3. Agencement selon la revendication 1, dans lequel le boîtier en matériau isolant (300) est réalisé en deux pièces et les deux pièces (302, 304) sont montées l'une dans l'autre, le corps métallique moulé (200) étant ainsi serré contre la deuxième extrémité de ressort et le ressort (100) en tant que tel étant légèrement contraint.

4. Agencement selon la revendication 1, dans lequel le ressort de contact (100) est réalisé sous forme de ressort hélicoïdal.

5. Agencement selon la revendication 1, dans lequel le deuxième dispositif de connexion (220) du corps métallique moulé (200) est réalisé comme connexion sertie avec le câble de connexion (500).

6. Agencement selon la revendication 1, dans lequel le dispositif de contact (400) pour le contact de la borne de commande traverse en partie au moins un évidement (652, 814) d'au moins un corps métallique moulé (650, 812) plat disposé entre le composant semi-conducteur de puissance (600) et le corps moulé (700), l'appendice en forme de goupille (110) étant ainsi électriquement relié à la surface de contact de commande (610) du composant semi-conducteur de puissance (600).

7. Agencement selon la revendication 1, dans lequel l'appendice en forme de goupille (110) du ressort de contact (100) du dispositif de contact (400) pour le contact de la borne auxiliaire est électriquement relié au corps métallique moulé (650, 812) plat disposé entre le composant semi-conducteur de puissance (600) et le corps moulé (700).

8. Agencement selon la revendication 1, dans lequel un évidement non central (720) est ménagé plus profondément dans le corps moulé (700) qu'un évidement central (710).
